(19) **Europäisches Patentamt / European Patent Office / Office européen des brevets**

(11) **EP 3 798 337 A1**

(12) # EUROPEAN PATENT APPLICATION
published in accordance with Art. 153(4) EPC

(43) Date of publication:
**31.03.2021 Bulletin 2021/13**

(21) Application number: **19891925.0**

(22) Date of filing: **11.11.2019**

(51) Int Cl.:
**C30B 15/22** (2006.01)  **C30B 29/06** (2006.01)

(86) International application number:
**PCT/CN2019/117202**

(87) International publication number:
**WO 2020/114207 (11.06.2020 Gazette 2020/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **03.12.2018 CN 201811465277**

(71) Applicant: **Longi Green Energy Technology Co., Ltd.**
**Xi'an, Shaanxi 710100 (CN)**

(72) Inventors:
• **WANG, Zhengyuan**
  Xi'an, Shaanxi 710100 (CN)
• **LI, Qiao**
  Xi'an, Shaanxi 710100 (CN)
• **XU, Zhanjun**
  Xi'an, Shaanxi 710100 (CN)

(74) Representative: **Loo, Chi Ching et al**
**Albright IP Limited**
**County House**
**Bayshill Road**
**Cheltenham, Gloucestershire GL50 3BA (GB)**

(54) **METHOD AND DEVICE FOR CONTROLLING CONSTANT-DIAMETER GROWTH OF MONOCRYSTAL SILICON AND STORAGE MEDIUM**

(57) A method and device for controlling constant-diameter growth of monocrystalline silicon and a storage medium, relating to the technical field of crystal fabrication, which can automatically adjust the controlling level of the crystal constant-diameter growth, to in turn control the crystal diameter better. The particular technical solution includes: acquiring PID initial values of an $i$-th cycle period; correcting the PID initial values of the $i$-th cycle period, and obtaining PID corrected values of the $i$-th cycle period; and according to the PID corrected values of the $i$-th cycle period, controlling a crystal growth diameter of the $i$-th cycle period. The present application is used to control constant-diameter growth of monocrystalline silicon.

```
                                                          ┌─ 101
  ┌─────────────────────────────────────────────┐
  │ acquiring PID initial values of an i-th      │
  │ cycle period                                 │
  └─────────────────────────────────────────────┘
                        │
                        ▼                          ┌─ 102
  ┌─────────────────────────────────────────────┐
  │ correcting the PID initial values of the     │
  │ i-th cycle period, and obtaining PID         │
  │ corrected values of the i-th cycle period    │
  └─────────────────────────────────────────────┘
                        │
                        ▼                          ┌─ 103
  ┌─────────────────────────────────────────────┐
  │ according to the PID corrected values of     │
  │ the i-th cycle period, controlling a crystal │
  │ growth diameter of the i-th cycle period     │
  └─────────────────────────────────────────────┘
```

Fig. 1

**EP 3 798 337 A1**

## Description

The present application claims the priority of the Chinese patent application filed on December 03rd, 2018 before the Chinese Patent Office with the application number of 201811465277.6 and the title of "METHOD AND DEVICE FOR CONTROLLING CONSTANT-DIAMETER GROWTH OF MONOCRYSTAL SILICON AND STORAGE MEDIUM", which is incorporated herein in its entirety by reference.

## TECHNICAL FIELD

The present disclosure relates to the technical field of crystal fabrication, and particularly relates to a method and device for controlling constant-diameter growth of monocrystalline silicon and a storage medium.

## BACKGROUND

The fabrication of czochralski silicon comprises placing the polycrystalline silicon material in to a quartz crucible, heating to melt into a silicon melt, and then performing the steps of temperature regulating, seeding, shouldering, shoulder circuiting, diameter equalization, closing and so on, to finally fabricate the monocrystalline silicon rod. In the process of constant-diameter growth of monocrystalline silicon, in conventional controlling modes, the controlling level during the entire constant-diameter growth is constant. However, in the earlier stage of the constant-diameter growth, the fluctuation of the diameter deviation of the crystal head is large, which requires a higher controlling level, but in the middle and later stages of the constant-diameter growth, the diameter fluctuation of the crystal decreases, which requires a lower controlling level. Therefore, the conventional controlling modes cannot satisfy the requirements on the controlling.

## SUMMARY

The above description is merely a summary of the technical solutions of the present application. In order to more clearly know the elements of the present application to enable the implementation according to the contents of the description, and in order to make one of the above and other purposes, features and advantages of the present application more apparent and understandable, particular embodiments of the present application will be provided below.

The embodiments of the present disclosure provide a method and device for controlling constant-diameter growth of monocrystalline silicon and a storage medium, which can automatically adjust the controlling level of the crystal constant-diameter growth, to in turn control the crystal diameter better. The technical solutions are as follows:

According to a first aspect of the embodiments of the present disclosure, there is provided a method for controlling constant-diameter growth of monocrystalline silicon, wherein the method comprises:

acquiring PID initial values of an $i$-th cycle period, wherein the PID initial values include an initial value of a proportion component P, an initial value of an integration component I and an initial value of a differentiation component D, and $i \geq 1$;

correcting the PID initial values of the $i$-th cycle period, and obtaining PID corrected values of the $i$-th cycle period, wherein the PID corrected values include a corrected value of the proportion component P, a corrected value of the integration component I and a corrected value of the differentiation component D; and

according to the PID corrected values of the $i$-th cycle period, controlling a crystal growth diameter of the $i$-th cycle period.

The method, by correcting in real time the PID values of each of the cycle periods in the process of the crystal constant-diameter growth, automatically adjusts the controlling level of the crystal constant-diameter growth, to in turn control the crystal diameter better.

In an embodiment, the method further comprises: the step of acquiring the PID initial values of the $i$-th cycle period comprises:

determining PID corrected values of an $(i-1)$-th cycle period to be the PID initial values of the $i$-th cycle period.

In an embodiment, the step of correcting the PID initial values of the $i$-th cycle period, and obtaining the PID corrected values of the $i$-th cycle period comprises:

setting, in the $i$-th cycle period, a target threshold of the proportion component P and a corresponding adaptive parameter, a target threshold of the integration component I and a corresponding adaptive parameter and a target threshold of the differentiation component D and a corresponding adaptive parameter;

according to the target threshold of the proportion component P and the corresponding adaptive parameter, calculating to obtain the corrected value of the proportion component P;

2

according to the target threshold of the integration component I and the corresponding adaptive parameter, calculating to obtain the corrected value of the integration component I; and

according to the target threshold of the differentiation component D and the corresponding adaptive parameter, calculating to obtain the corrected value of the differentiation component D.

In an embodiment, the step of setting the target threshold of the proportion component P of the *i*-th cycle period and the corresponding adaptive parameter comprises:

acquiring a diameter difference of the *i*-th cycle period, wherein the diameter difference is a difference between a target crystal diameter and a real-time crystal diameter;
setting 1/100-1/2 of an absolute value of the diameter difference of the *i*-th cycle period to be the target threshold of the proportion component P;
setting 1/1000-1/10000 of the initial value of the proportion component P of the *i*-th cycle period to be a first adaptive parameter of the proportion component P; and
setting 1/10000-1/100000 of the initial value of the proportion component P of the *i*-th cycle period to be a second adaptive parameter of the proportion component P.

In an embodiment, the step of acquiring the diameter difference of the *i*-th cycle period comprises:

collecting an initial crystal diameter of the *i*-th cycle period;
setting the target crystal diameter of the *i*-th cycle period; and
according to the crystal growth diameter of the *i*-th cycle period and the target crystal diameter of the *i*-th cycle period, calculating to obtain the diameter difference of the *i*-th cycle period.

In an embodiment, the step of setting the target threshold of the integration component I of the *i*-th cycle period and the corresponding adaptive parameter comprises:

acquiring diameter differences of the *i*-th cycle period and *M* cycle periods preceding the *i*-th cycle period, wherein $M \leq i-1$;
calculating an average value of all of the diameter differences of the *M*+1 cycle periods;
setting 1/100-1/2 of the average value to be the target threshold of the integration component I;
setting 1/1000-1/10000 of the initial value of the integration component I of the *i*-th cycle period to be a first adaptive parameter of the integration component I; and
setting 1/10000-1/100000 of the initial value of the integration component I of the *i*-th cycle period to be a second adaptive parameter of the integration component I.

In an embodiment, the step of setting the target threshold of the differentiation component D of the *i*-th cycle period and the corresponding adaptive parameter comprises:

acquiring diameter differences of the *i*-th cycle period and *M* cycle periods preceding the *i*-th cycle period, wherein $M \leq i-1$;
calculating a standard deviation of all of the diameter differences of the *M*+1 cycle periods;
setting 1/100-1/2 of the standard deviation to be the target threshold of the differentiation component D;
setting 1/1000-1/10000 of the initial value of the differentiation component D of the *i*-th cycle period to be a first adaptive parameter of the differentiation component D; and
setting 1/10000-1/100000 of the initial value of the differentiation component D of the *i*-th cycle period to be a second adaptive parameter of the differentiation component D.

In an embodiment, the step of, according to the target threshold of the proportion component P and the corresponding adaptive parameter, calculating to obtain the corrected value of the proportion component P comprises:
according to the diameter difference of the *i*-th cycle period and the target threshold of the proportion component P and the corresponding adaptive parameter, by using a first formula, calculating to obtain the corrected value of the proportion component P, wherein the first formula comprises:

$$P_{i_{corrected}} = P_{(i-1)_{corrected}} + \left(\left|D_{i_{err}}\right| - P_{i_{threshold}}\right) \times \alpha_{i_{a1}} + \int_0^t \left(\left|D_{i_{err}}\right| - P_{i_{threshold}}\right) \times \beta_{i_{a1}}$$

wherein $P_{i_{corrected}}$ represents the corrected value of the proportion component P of the $i$-th cycle period, $P_{(i-1)corrected}$ represents the initial value of the proportion component P of the $i$-th cycle period, $D_{ierr}$ represents the diameter difference of the $i$-th cycle period, $\alpha_{i_{a1}}$ represents the first adaptive parameter of the proportion component P of the $i$-th cycle period, $\beta_{i_{a1}}$ represents the second adaptive parameter of the proportion component P of the $i$-th cycle period, $P_{i_{threshold}}$ represents the target threshold of the proportion component P of the $i$-th cycle period, and $t$ represents the duration of the cycle period.

In an embodiment, the step of, according to the diameter difference and the target threshold of the integration component I and the corresponding adaptive parameter, calculating to obtain the corrected value of the integration component I comprises:

according to the diameter difference and the target threshold of the integration component I and the corresponding adaptive parameter, by using a second formula, calculating to obtain the corrected value of the integration component I, wherein the second formula comprises:

$$I_{i_{corrected}} = I_{(i-1)_{corrected}} + \left( \overline{|D_{j_{err}}|} - I_{i_{threshold}} \right) \times \alpha_{i_{a2}} + \int_0^t \left( \overline{|D_{j_{err}}|} - I_{i_{threshold}} \right) \times \beta_{i_{a2}}$$

wherein $I_{i_{corrected}}$ represents the corrected value of the integration component I of the $i$-th cycle period, $I_{(i-1)_{corrected}}$ represents the initial value of the integration component I of the $i$-th cycle period, $D_{j_{err}}$ represents the diameter difference of the $i$-th cycle period in $M$+1 cycle periods, $\overline{D_{j_{err}}}$ represents the average value of the absolute values of all of the diameter differences in the $M$+1 cycle periods, $\alpha_{i_{a2}}$ represents the first adaptive parameter of the integration component I of the $i$-th cycle period, $\beta_{i_{a2}}$ represents the second adaptive parameter of the integration component I of the $i$-th cycle period, $I_{i_{threshold}}$ represents the target threshold of the integration component I of the $i$-th cycle period, and t represents the duration of the cycle period.

In an embodiment, the step of, according to the target threshold of the differentiation component D and the corresponding adaptive parameter, calculating to obtain the corrected value of the differentiation component D comprises:

according to the diameter difference and the target threshold of the differentiation component D and the corresponding adaptive parameter, by using a third formula, calculating to obtain the corrected value of the differentiation component D, wherein the third formula comprises:

$$D_{i_{corrected}} = D_{(i-1)_{corrected}} + \left( \sqrt{\frac{1}{M+1} \sum \left( |D_{j_{err}}| \right)^2} - D_{i_{threshold}} \right) \times \alpha_{i_{a3}} + \int_0^t \left( \sqrt{\frac{1}{M+1} \sum \left( |D_{j_{err}}| \right)^2} - D_{i_{threshold}} \right) \times \beta_{i_{a3}}$$

wherein $D_{i_{corrected}}$ represents the corrected value of the differentiation component D of the $i$-th cycle period, $D_{(i-1)corrected}$ represents the initial value of the differentiation component D of the $i$-th cycle period, $D_{j_{err}}$ represents the diameter difference of the $i$-th cycle period in $M$+1 cycle periods, $D_{i_{threshold}}$ represents the target threshold of the differentiation component D of the $i$-th cycle period, $\alpha_{i_{a3}}$ represents the first adaptive parameter of the differentiation component D of the $i$-th cycle period, $\beta_{i_{a3}}$ represents the second adaptive parameter of the differentiation component D of the $i$-th cycle period, and $t$ represents the duration of the cycle period.

According to a second aspect of the embodiments of the present disclosure, there is provided an apparatus for controlling constant-diameter growth of monocrystalline silicon, comprising: an acquiring module, a correcting module and a controlling module;

the acquiring module is configured for acquiring PID initial values of an $i$-th cycle period, wherein the PID initial values include an initial value of a proportion component P, an initial value of an integration component I and an initial value of a differentiation component D, and $i \geq 1$;

the correcting module is configured for correcting the PID initial values of the $i$-th cycle period, and obtaining PID corrected values of the $i$-th cycle period, wherein the PID corrected values include a corrected value of the proportion component P, a corrected value of the integration component I and a corrected value of the differentiation component D; and

the controlling module is configured for, according to the PID corrected values of the $i$-th cycle period, controlling a crystal growth diameter of the $i$-th cycle period.

In an embodiment, the acquiring module is configured for determining PID corrected values of an ($i$-1)-th cycle period to be the PID initial values of the $i$-th cycle period.

In an embodiment, the correcting module comprises: a setting module and a calculating module;

the setting module is configured for setting, in the $i$-th cycle period, a target threshold of the proportion component P and a corresponding adaptive parameter, a target threshold of the integration component I and a corresponding adaptive parameter and a target threshold of the differentiation component D and a corresponding adaptive parameter;

the calculating module is configured for, according to the target threshold of the proportion component P and the corresponding adaptive parameter, calculating to obtain the corrected value of the proportion component P;

the calculating module is configured for, according to the target threshold of the integration component I and the corresponding adaptive parameter, calculating to obtain the corrected value of the integration component I; and

the calculating module is configured for, according to the target threshold of the differentiation component D and the corresponding adaptive parameter, calculating to obtain the corrected value of the differentiation component D.

In an embodiment, the setting module comprises: an acquiring module and a setting module;

the acquiring module is configured for acquiring a diameter difference of the $i$-th cycle period;

the setting module is configured for setting 1/100-1/2 of an absolute value of the diameter difference of the $i$-th cycle period to be the target threshold of the proportion component P;

the setting module is configured for setting 1/1000-1/10000 of the initial value of the proportion component P of the $i$-th cycle period to be a first adaptive parameter of the proportion component P; and

the setting module is configured for setting 1/10000-1/100000 of the initial value of the proportion component P of the $i$-th cycle period to be a second adaptive parameter of the proportion component P.

In an embodiment, the setting module further comprises a calculating module;

the acquiring module is configured for acquiring diameter differences of the $i$-th cycle period and $M$ cycle periods preceding the $i$-th cycle period, wherein $M \leq i-1$;

the calculating module is configured for calculating an average value of all of the diameter differences of the $M+1$ cycle periods;

the setting module is configured for setting 1/100-1/2 of the average value to be the target threshold of the integration component I;

the setting module is configured for setting 1/1000-1/10000 of the initial value of the integration component I of the $i$-th cycle period to be a first adaptive parameter of the integration component I; and

the setting module is configured for setting 1/10000-1/100000 of the initial value of the integration component I of the $i$-th cycle period to be a second adaptive parameter of the integration component I.

In an embodiment, the acquiring module is configured for acquiring diameter differences of the $i$-th cycle period and $M$ cycle periods preceding the $i$-th cycle period, wherein $M \leq i-1$;

the calculating module is configured for calculating a standard deviation of all of the diameter differences of the $M+1$ cycle periods;

the setting module is configured for setting 1/100-1/2 of the standard deviation to be the target threshold of the differentiation component D;

the setting module is configured for setting 1/1000-1/10000 of the initial value of the differentiation component D of the $i$-th cycle period to be a first adaptive parameter of the differentiation component D; and

the setting module is configured for setting 1/10000-1/100000 of the initial value of the differentiation component D of the $i$-th cycle period to be a second adaptive parameter of the differentiation component D.

In an embodiment, the calculating module is configured for, according to the diameter difference of the $i$-th cycle period and the target threshold of the proportion component P and the corresponding adaptive parameter, by using a first formula, calculating to obtain the corrected value of the proportion component P, wherein the first formula comprises:

$$P_{i_{\text{corrected}}} = P_{(i-1)_{\text{corrected}}} + \left( \left| D_{i_{err}} \right| - P_{i_{\text{threshold}}} \right) \times \alpha_{i_{a1}} + \int_0^t \left( \left| D_{i_{err}} \right| - P_{i_{\text{threshold}}} \right) \times \beta_{i_{a1}}$$

wherein $P_{i_{\text{corrected}}}$ represents the corrected value of the proportion component P of the $i$-th cycle period, $P_{(i-1)_{\text{corrected}}}$ represents the initial value of the proportion component P of the $i$-th cycle period, $D_{i_{err}}$ represents the diameter difference of the $i$-th cycle period, $\alpha_{i_{a1}}$ represents the first adaptive parameter of the proportion component P of the $i$-th cycle period, $\beta_{i_{a1}}$ represents the second adaptive parameter of the proportion component P of the $i$-th cycle period, $P_{i_{\text{threshold}}}$ represents the target threshold of the proportion component P of the $i$-th cycle period, and t represents the duration of the cycle period.

In an embodiment, the calculating module is configured for, according to the diameter difference and the target threshold of the integration component I and the corresponding adaptive parameter, by using a second formula, calculating to obtain the corrected value of the integration component I, wherein the second formula comprises:

$$I_{i_{\text{corrected}}} = I_{(i-1)_{\text{corrected}}} + \left( \overline{\left| D_{j_{err}} \right|} - I_{i_{\text{threshold}}} \right) \times \alpha_{i_{a2}} + \int_0^t \left( \overline{\left| D_{j_{err}} \right|} - I_{i_{\text{threshold}}} \right) \times \beta_{i_{a2}}$$

wherein $I_{i_{\text{corrected}}}$ represents the corrected value of the integration component I of the $i$-th cycle period, $I_{(i-1)_{\text{corrected}}}$ represents the initial value of the integration component I of the $i$-th cycle period, $D_{j_{err}}$ represents the diameter difference of the $i$-th cycle period in $M+1$ cycle periods, $\overline{|D_{j_{err}}|}$ represents the average value of the absolute values of all of the diameter differences in the $M+1$ cycle periods, $\alpha_{i_{a2}}$ represents the first adaptive parameter of the integration component I of the $i$-th cycle period, $\beta_{i_{a2}}$ represents the second adaptive parameter of the integration component I of the $i$-th cycle period, $I_{i_{threshold}}$ represents the target threshold of the integration component I of the $i$-th cycle period, and t represents the duration of the cycle period.

In an embodiment, the calculating module is configured for, according to the diameter difference and the target threshold of the differentiation component D and the corresponding adaptive parameter, by using a third formula, calculating to obtain the corrected value of the differentiation component D, wherein the third formula comprises:

$$D_{i_{corrected}} = D_{(i-1)_{corrected}} + \left( \sqrt{\frac{1}{M+1} \sum \left( \left| D_{j_{err}} \right| \right)^2} - D_{i_{threshold}} \right) \times \alpha_{i_{a3}} + \int_0^t \left( \sqrt{\frac{1}{M+1} \sum \left( \left| D_{j_{err}} \right| \right)^2} - D_{i_{threshold}} \right) \times \beta_{i_{a3}}$$

wherein $D_{i_{corrected}}$ represents the corrected value of the differentiation component D of the $i$-th cycle period, $D_{(i-1)_{corrected}}$ represents the initial value of the differentiation component D of the $i$-th cycle period, $D_{j_{err}}$ represents the diameter difference of the $i$-th cycle period in $M+1$ cycle periods, $D_{i_{threshold}}$ represents the target threshold of the differentiation component D of the $i$-th cycle period, $\alpha_{i_{a3}}$ represents the first adaptive parameter of the differentiation component D of the $i$-th cycle period, $\beta_{i_{a3}}$ represents the second adaptive parameter of the differentiation component D of the $i$-th cycle period, and $t$ represents the duration of the cycle period.

According to a third aspect of the embodiments of the present disclosure, there is provided a device for controlling constant-diameter growth of monocrystalline silicon, wherein the device for controlling constant-diameter growth of monocrystalline silicon comprises a processor and a memory, the memory stores at least one computer instruction, and the computer instruction is loaded and executed by the processor to implement the steps of the method for controlling constant-diameter growth of monocrystalline silicon described by the first aspect and any one of the embodiments of the first aspect.

According to a fourth aspect of the embodiments of the present disclosure, there is provided a computer-readable storage medium, wherein the storage medium stores at least one computer instruction, and the computer instruction is loaded and executed by a processor to implement the steps of the method for controlling constant-diameter growth of monocrystalline silicon described by the first aspect and any one of the embodiments of the first aspect.

It should be understood that the above general description and the following detailed description are merely exemplary and explanatory, and cannot limit the present disclosure.

BRIEF DESCRIPTION OF THE DRAWINGS

In order to more clearly illustrate the technical solutions of the embodiments of the present application or the prior art, the figures that are required to describe the embodiments or the prior art will be briefly introduced below. Apparently, the figures that are described below are embodiments of the present application, and a person skilled in the art can obtain other figures according to these figures without paying creative work.

The drawings here are incorporated into the description and form part of the description. The drawings show the embodiments of the present disclosure, and interpret the principle of the present disclosure together with the description.

Fig. 1 is a flow chart of the method for controlling constant-diameter growth of monocrystalline silicon according to an embodiment of the present disclosure;
Fig. 2 is curves of the variations of the crystal-pulling-rate fluctuation amplitude and the crystal-diameter deviation with the crystal constant-diameter length according to an embodiment of the present disclosure, wherein the PID values are not corrected;
Fig. 3 is curves of the variations of the crystal-pulling-rate fluctuation amplitude and the crystal-diameter deviation with the crystal constant-diameter length according to an embodiment of the present disclosure, wherein the PID values have been corrected;
Fig. 4 is a structural diagram of the apparatus for controlling constant-diameter growth of monocrystalline silicon according to an embodiment of the present disclosure;
Fig. 5 is a structural diagram of the apparatus for controlling constant-diameter growth of monocrystalline silicon according to an embodiment of the present disclosure;
Fig. 6 is a structural diagram of the apparatus for controlling constant-diameter growth of monocrystalline silicon according to an embodiment of the present disclosure; and

Fig. 7 is a structural diagram of the device for controlling constant-diameter growth of monocrystalline silicon according to an embodiment of the present disclosure.

DETAILED DESCRIPTION

In order to make one of the objects, the technical solutions and the advantages of the embodiments of the present application clearer, the technical solutions of the embodiments of the present application will be clearly and completely described below with reference to the drawings of the embodiments of the present application. Apparently, the described embodiments are merely certain embodiments of the present application, rather than all of the embodiments. All of the other embodiments that a person skilled in the art obtains on the basis of the embodiments of the present application without paying creative work fall within the protection scope of the present application.

Here the exemplary embodiments are in detail described, the examples of which are illustrated in the drawings. Where the description below involves the drawings, unless otherwise indicated, the same numbers in different figures denote the same or similar elements. The implementations described in the following exemplary embodiments do not represent all of the embodiments of the present disclosure. In contrast, they are merely examples of the devices and the methods according to some aspects of the present disclosure as described in detail in the attached claims.

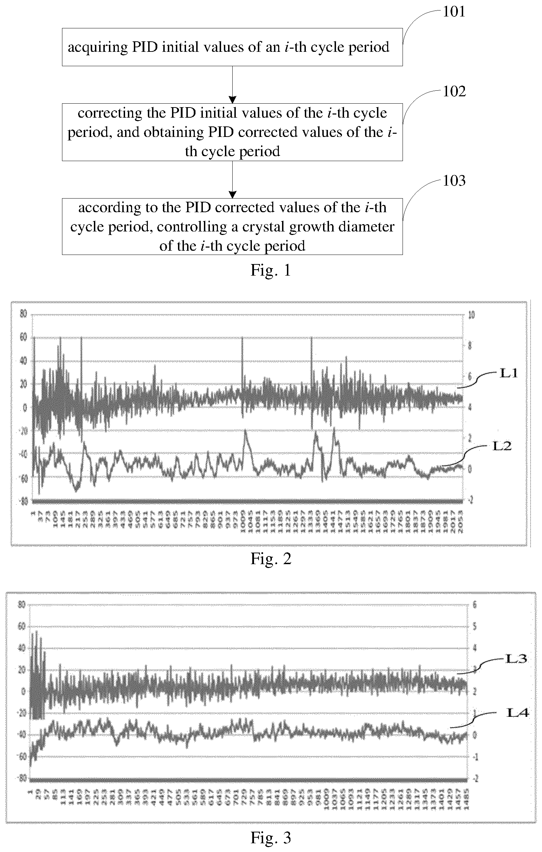

An embodiment of the present disclosure provides a method for controlling constant-diameter growth of monocrystalline silicon. As shown in Fig. 1, the method for controlling constant-diameter growth of monocrystalline silicon comprises the steps of:

101: acquiring PID initial values of an $i$-th cycle period.

In an embodiment of the present disclosure, the step of acquiring the PID initial values of the $i$-th cycle period comprises: determining PID corrected values of an ($i$-1)-th cycle period to be the PID initial values of the $i$-th cycle period. In other words, the PID initial values of the current cycle period are the PID corrected values of the previous one cycle period. The PID initial values include an initial value of a proportion component P, an initial value of an integration component I and an initial value of a differentiation component D, and $i \geq 1$.

Exemplarily, when $i=1$, the PID initial values of the first cycle period are $P_0$, $I_0$ and $D_0$. Generally, the $P_0$, $I_0$ and $D_0$ are determined according to empiric values. In physical production process, the PID initial values are determined according to the deviation of the actual crystal growth diameter from the target crystal diameter. When $i=2$, the PID initial values of the second cycle period are the PID corrected values of the first cycle period, i.e., $P_{1\text{corrected}}$, $I_{1\text{corrected}}$ and $D_{1\text{corrected}}$. When $i=3$, the PID initial values of the third cycle period are the PID corrected values of the second cycle period, i.e., $P_{2\text{corrected}}$, $I_{2\text{corrected}}$ and $D_{2\text{corrected}}$. The rest can be done in the same manner. When $i=N$, the PID initial values of the $N$-th cycle period are the PID corrected values of the ($N$-1)-th cycle period, i.e., $P_{(N-1)\text{corrected}}$, $I_{(N-1)\text{corrected}}$ and $D_{(N-1)\text{corrected}}$. When $i=N+1$, the PID initial values of the ($N$+1)-th cycle period are the PID corrected values of the $N$-th cycle period, i.e., $P_{N\text{corrected}}$, $I_{N\text{corrected}}$ and $D_{N\text{corrected}}$..

102: correcting the PID initial values of the $i$-th cycle period, and obtaining PID corrected values of the $i$-th cycle period.

In an embodiment of the present disclosure, the PID corrected values include a corrected value of the proportion component P, a corrected value of the integration component I and a corrected value of the differentiation component D.

By referring to the description of the step 101, when $i=1$, the corrected values corresponding to the initial values of the P value, the I value and the D value $P_0$, $I_0$ and $D_0$ are $P_{1\text{corrected}}$, $I_{1\text{corrected}}$ and $D_{1\text{corrected}}$. When $i=2$, the initial values of the P value, the I value and the D value are $P_{1\text{corrected}}$, $I_{1\text{corrected}}$ and $D_{1\text{corrected}}$, and the corresponding corrected values are $P_{2\text{corrected}}$, $I_{2\text{corrected}}$ and $D_{2\text{corrected}}$. When $i=3$, the initial values of the P value, the I value and the D value are $P_{2\text{corrected}}$, $I_{2\text{corrected}}$ and $D_{2\text{corrected}}$, and the corresponding corrected values are $P_{3\text{corrected}}$, $I_{3\text{corrected}}$ and $D_{3\text{corrected}}$. The rest can be done in the same manner. When $i=N$, the initial values of the P value, the I value and the D value are $P_{(N-1)\text{corrected}}$, $I_{(N-1)\text{corrected}}$ and $D_{(N-1)\text{corrected}}$, and the corresponding corrected values are $P_{N\text{corrected}}$, $I_{N\text{corrected}}$ and $D_{N\text{corrected}}$.

Particularly, the step 102 comprises the following steps:

S1: setting, in the $i$-th cycle period, a target threshold of the proportion component P and a corresponding adaptive parameter, a target threshold of the integration component I and a corresponding adaptive parameter and a target threshold of the differentiation component D and a corresponding adaptive parameter.

Sequentially particularly described below are the setting of the target threshold of the proportion component P and the corresponding adaptive parameter, the target threshold of the integration component I and the corresponding adaptive parameter and the target threshold of the differentiation component D and the corresponding adaptive parameter.

Firstly, the step of setting the target threshold of the proportion component P of the $i$-th cycle period and the corresponding adaptive parameter comprises:

acquiring a diameter difference of the $i$-th cycle period;
setting 1/100-1/2 of an absolute value of the diameter difference of the $i$-th cycle period to be the target threshold of the proportion component P;

setting 1/1000-1/10000 of the initial value of the proportion component P of the $i$-th cycle period to be a first adaptive parameter of the proportion component P; and

setting 1/10000-1/100000 of the initial value of the proportion component P of the $i$-th cycle period to be a second adaptive parameter of the proportion component P.

the step of acquiring the diameter difference of the $i$-th cycle period comprises: collecting an initial crystal diameter of the $i$-th cycle period, wherein the initial crystal diameter is the actual diameter of the crystal growth; and setting the target crystal diameter of the $i$-th cycle period, and then calculating to obtain the diameter difference between the target crystal diameter and the initial crystal diameter of the $i$-th cycle period. Because the diameter difference between the target crystal diameter and the initial crystal diameter may have a negative value, in the embodiments of the present disclosure, when the diameter difference is processed, all of the diameter differences are required to obtain the absolute values. Further, 1/100-1/2 of the absolute value of the diameter difference of the $i$-th cycle period is set to be the target threshold of the proportion component P of the $i$-th cycle period. The adaptive parameter of the proportion component P of the $i$-th cycle period is determined according to the initial value of the proportion component P of the $i$-th cycle period.

Secondly, the step of setting the target threshold of the integration component I of the $i$-th cycle period and the corresponding adaptive parameter comprises:

acquiring diameter differences of the $i$-th cycle period and $M$ cycle periods preceding the $i$-th cycle period;
calculating an average value of all of the diameter differences of the $M+1$ cycle periods;
setting 1/100-1/2 of the average value to be the target threshold of the integration component I;
determining 1/1000-1/10000 of the initial value of the integration component I of the $i$-th cycle period to be a first adaptive parameter of the integration component I; and
determining 1/10000-1/100000 of the initial value of the integration component I of the $i$-th cycle period to be a second adaptive parameter of the integration component I.

It should be noted that the $M$ herein refers to the quantity of the selected cycle periods, $M \leq i-1$. Therefore, when $M=i-1$, that means acquiring the diameter differences of all of the cycle periods preceding the $i$-th cycle period. When $M<i-1$, that means acquiring the diameter differences of $M$ cycle periods that are neighboring the $i$-th cycle period and are successive. The size of $M$ may be selected according to the actual condition.

The mode of acquiring the diameter difference of the $i$-th cycle period may refer to the step of acquiring the diameter difference of the $i$-th cycle period when setting the target threshold of the proportion component P, and is not discussed here further. Because the $M$ cycle periods preceding the $i$-th cycle period have already completed the controlling on the crystal diameter, the process may comprise acquiring the diameter differences of the $M$ cycle periods preceding the $i$-th cycle period from history data; then, solving the average value of the absolute values of all of the diameter differences of the $M+1$ cycle periods; and in turn, setting 1/100-1/2 of the average value to be the target threshold of the integration component I. The adaptive parameter of the integration component I of the $i$-th cycle period is determined according to the initial value of the integration component I of the $i$-th cycle period.

Thirdly, setting the target threshold of the differentiation component D of the $i$-th cycle period and the corresponding adaptive parameter comprises:

acquiring the diameter differences of each of the $M$ cycle periods preceding the $i$-th cycle period;
calculating a standard deviation of all of the diameter differences of the $M+1$ cycle periods;
setting 1/100-1/2 of the standard deviation to be the target threshold of the differentiation component D;
determining 1/1000-1/10000 of the initial value of the differentiation component D of the $i$-th cycle period to be a first adaptive parameter of the differentiation component D; and
determining 1/10000-1/100000 of the initial value of the differentiation component D of the $i$-th cycle period to be a second adaptive parameter of the differentiation component D.

It should be noted that the $M$ cycle periods here are the same as the above $M$ cycle periods in the setting of the target threshold of the integration component I. Therefore, the process comprises, according to the absolute values of all of the diameter differences of the $M+1$ cycle periods and the average value of the absolute values of all of the diameter differences of the $M+1$ cycle periods, calculating to obtain the standard deviation of the absolute values of all of the diameter differences of the $M+1$ cycle periods, and setting 1/100-1/2 of the standard deviation to be the target threshold of the differentiation component D. The adaptive parameter of the differentiation component D of the $i$-th cycle period is determined according to the initial value of the differentiation component D of the $i$-th cycle period.

S2: according to the target threshold of the proportion component P and the corresponding adaptive parameter, calculating to obtain the corrected value of the proportion component P.

Particularly, the step S2 comprises: according to the diameter difference of the *i*-th cycle period and the target threshold of the proportion component P of the *i*-th cycle period and the corresponding adaptive parameter, by using a first formula, calculating to obtain the corrected value of the proportion component P of the *i*-th cycle period, wherein the first formula comprises:

$$P_{i_{\text{corrected}}} = P_{(i-1)_{\text{corrected}}} + \left( \left| D_{i_{err}} \right| - P_{i_{\text{threshold}}} \right) \times \alpha_{i_{a1}} + \int_0^t \left( \left| D_{i_{err}} \right| - P_{i_{\text{threshold}}} \right) \times \beta_{i_{a1}}$$

wherein $P_{i_{\text{corrected}}}$ represents the corrected value of the proportion component P of the *i*-th cycle period, $P_{(i-1)_{\text{corrected}}}$ represents the initial value of the proportion component P of the *i*-th cycle period, $D_{i_{err}}$ represents the diameter difference of the *i*-th cycle period, $|D_{i_{err}}|$ represents the absolute value of the diameter difference of the *i*-th cycle period, $\alpha_{i_{a1}}$ represents the first adaptive parameter of the proportion component P of the *i*-th cycle period, $\beta_{i_{a1}}$ represents the second adaptive parameter of the proportion component P of the *i*-th cycle period, $P_{i_{\text{threshold}}}$ represents the target threshold of the proportion component P of the *i*-th cycle period, and t represents the duration of the cycle period.

S3: according to the target threshold of the integration component I and the corresponding adaptive parameter, calculating to obtain the corrected value of the integration component I.

Particularly, the step S3 comprises: according to the diameter difference of the *i*-th cycle period, the diameter differences of the M cycle periods preceding the *i*-th cycle period and the target threshold of the integration component I of the *i*-th cycle period and the corresponding adaptive parameter, by using a second formula, calculating to obtain the corrected value of the integration component I of the *i*-th cycle period, wherein the second formula comprises:

$$I_{i_{\text{corrected}}} = I_{(i-1)_{\text{corrected}}} + \left( \overline{\left| D_{j_{err}} \right|} - I_{i_{\text{threshold}}} \right) \times \alpha_{i_{a2}} + \int_0^t \left( \overline{\left| D_{j_{err}} \right|} - I_{i_{\text{threshold}}} \right) \times \beta_{i_{a2}}$$

wherein $I_{i_{\text{corrected}}}$ represents the corrected value of the integration component I of the *i*-th cycle period, $I_{(i-1)_{\text{corrected}}}$ represents the initial value of the integration component I of the *i*-th cycle period, $D_{j_{err}}$ represents the diameter difference of the *i*-th cycle period in *M*+1 cycle periods, $\overline{|D_{j_{err}}|}$ represents the average value of the absolute values of all of the diameter differences in the *M*+1 cycle periods, *M* represents the quantity of the cycle periods, $\alpha_{i_{a2}}$ represents the first adaptive parameter of the integration component I of the *i*-th cycle period, $\beta_{i_{a2}}$ represents the second adaptive parameter of the integration component I of the *i*-th cycle period, $I_{i_{\text{threshold}}}$ represents the target threshold of the integration component I of the *i*-th cycle period, and t represents the duration of the cycle period.

S4: according to the target threshold of the differentiation component D and the corresponding adaptive parameter, calculating to obtain the corrected value of the differentiation component D.

Particularly, the step S4 comprises: according to the diameter difference of the *i*-th cycle period, the diameter differences of the M cycle periods preceding the *i*-th cycle period, the initial value of the differentiation component D of the *i*-th cycle period and the target threshold of the differentiation component D of the *i*-th cycle period and the corresponding adaptive parameter, by using a third formula, calculating to obtain the corrected value of the differentiation component D, wherein the third formula comprises:

$$D_{i_{\text{corrected}}} = D_{(i-1)_{\text{corrected}}} + \left( \sqrt{\frac{1}{M+1} \sum \left( \left| D_{j_{err}} \right| \right)^2} - D_{i_{\text{threshold}}} \right) \times \alpha_{i_{a3}} + \int_0^t \left( \sqrt{\frac{1}{M+1} \sum \left( \left| D_{j_{err}} \right| \right)^2} - D_{i_{\text{threshold}}} \right) \times \beta_{i_{a3}}$$

wherein $D_{i_{\text{corrected}}}$ represents the corrected value of the differentiation component D of the *i*-th cycle period, $D_{(i-1)_{\text{corrected}}}$ represents the initial value of the differentiation component D of the *i*-th cycle period, $D_{j_{err}}$ represents the diameter difference of the *j*-th cycle period in *M* cycle periods, $D_{i_{\text{threshold}}}$ represents the target threshold of the differentiation component D of the *i*-th cycle period, $\alpha_{i_{a3}}$ represents the first adaptive parameter of the differentiation component D of the *i*-th cycle period, $\beta_{i_{a3}}$ represents the second adaptive parameter of the differentiation component D of the *i*-th cycle period, and t represents the duration of the cycle period.

103: according to the PID corrected values of the *i*-th cycle period, controlling a crystal growth diameter of the *i*-th cycle period.

After the PID corrected values of the *i*-th cycle period have been obtained, the PID controlling method is used to control the crystal growth of the $i$-th cycle period. Particularly, the PID controlling method may be used to control the crystal growth speed, and in turn control the crystal growth diameter, and the PID controlling method may also be used to control the crystal growth temperature, and in turn control the crystal growth diameter.

The method for controlling constant-diameter growth of monocrystalline silicon according to the embodiments of the present disclosure acquires PID initial values of an $i$-th cycle period; corrects the PID initial values of the $i$-th cycle period, and obtains PID corrected values of the $i$-th cycle period; and according to the PID corrected values of the $i$-th cycle period, controls a crystal growth diameter of the $i$-th cycle period. The method, by correcting in real time the PID values of each of the cycle periods in the process of the crystal constant-diameter growth, automatically adjusts the controlling level of the crystal constant-diameter growth, to in turn control the crystal diameter better.

On the basis of the method for controlling constant-diameter growth of monocrystalline silicon according to the above embodiment corresponding to Fig. 1, another embodiment of the present disclosure provides a method for controlling constant-diameter growth of monocrystalline silicon. The method for controlling constant-diameter growth of monocrystalline silicon according to the present embodiment employs the PID controlling method, by automatically correcting the PID parameter values in the cycle periods by using a single-crystal-furnace controlling system, to in turn control the crystal diameter. The method comprises mainly the steps of: firstly, setting the initial values corresponding to the P value, the I value and the D value; then, setting the target thresholds corresponding to the P value, the I value and the D value and the adaptive parameters corresponding to the P value, the I value and the D value, correcting the initial values, and outputting the corrected values; and, finally, by using the corrected values corresponding to the P value, the I value and the D value, controlling the crystal diameter by using the PID controlling method. The above steps will be particularly described below.

The first step: setting the initial values.

The present embodiment comprises performing the circulation with t as the duration of the cycle periods, within the $i$-th cycle period, setting the initial values of the P value, the I value and the D value to be respectively $P_{(i-1)\text{corrected}}$, $I_{(i-1)\text{corrected}}$ and $D_{(i-1)\text{corrected}}$, and calculating out that the corrected values corresponding to the initial values $P_{(i-1)\text{corrected}}$, $I_{(i-1)\text{corrected}}$ and $D_{(i-1)\text{corrected}}$ are $P_{i\text{corrected}}$, $I_{i\text{corrected}}$ and $D_{i\text{corrected}}$.

Exemplarily, when $i=1$, the initial values $P_{(i-1)\text{corrected}}$, $I_{(i-1)\text{corrected}}$ and $D_{(i-1)\text{corrected}}$ of the P value, the I value and the D value are respectively $P_0$, $I_0$ and $D_0$, and it is calculated out that the corrected values corresponding to the initial values $P_0$, $I_0$ and $D_0$ are $P_{1\text{corrected}}$, $I_{1\text{corrected}}$ and $D_{1\text{corrected}}$.
When $i=2$, the initial values of the P value, the I value and the D value are $P_{1\text{corrected}}$, $I_{1\text{corrected}}$ and $D_{1\text{corrected}}$, and it is calculated out that the corrected values corresponding to the initial values $P_{1\text{corrected}}$, $I_{1\text{corrected}}$ and $D_{1\text{corrected}}$ are $P_{2\text{corrected}}$, $I_{2\text{corrected}}$ and $D_{2\text{corrected}}$.

When $i=3$, the initial values of the P value, the I value and the D value are $P_{2\text{corrected}}$, $I_{2\text{corrected}}$ and $D_{2\text{corrected}}$, and it is calculated out that the corrected values corresponding to the initial values $P_{2\text{corrected}}$, $I_{2\text{corrected}}$ and $D_{2\text{corrected}}$ are $P_{3\text{corrected}}$, $I_{3\text{corrected}}$ and $D_{3\text{corrected}}$.

The rest can be done in the same manner. It is calculated out that the corrected values of the $N$-th cycle period are $P_{N\text{corrected}}$, $I_{N\text{corrected}}$ and $D_{N\text{corrected}}$.

The initial values $P_0$, $I_0$ and $D_0$ are determined empirically. In physical production process, the PID initial values are determined according to the deviation of the actual crystal growth diameter from the target crystal diameter.

The second step: correcting the initial values.

The particular process of the correction of the corrected values corresponding to the initial values mainly comprises: setting the target thresholds of the P value, the I value and the D value and the adaptive parameters corresponding to the P value, the I value and the D value; and correcting the initial values of the P value, the I value and the D value, and outputting the corrected values. The process particularly comprises:

Step 1: within the $i$-th cycle period, setting a target crystal diameter, and calculating out the difference between a system-fed-back diameter from the controlling system and the target crystal diameter; and acquiring the diameter differences of the $M$ cycle periods preceding the $i$-th cycle period.

Step 2: setting the target thresholds corresponding to the P value, the I value and the D value $P_{i\text{threshold}}$, $I_{i\text{threshold}}$ and $D_{i\text{threshold}}$ and the adaptive parameters corresponding to the P value, the I value and the D value, and the setting methods are respectively as follows:

a. setting the target threshold of the P value $P_{i\text{threshold}}$, and the adaptive parameters corresponding to the P value
The target threshold $P_{i\text{threshold}}$: within the $i$-th cycle period, the target threshold $P_{i\text{threshold}}$ is set to be 1/100 to 1/2 of the absolute value of the $D_{i\text{err}}$.
The adaptive parameters corresponding to the P value include: $\alpha_{i_{a1}}$ and $\beta_{i_{a1}}$, wherein the $\alpha_{i_{a1}}$ is set to be 1/1000 to 1/10000 of the $P_{(i-1)\text{corrected}}$, and the $\beta_{i_{a1}}$ is set to be 1/10000 to 1/100000 of the $P_{(i-1)\text{corrected}}$.
b. setting the target threshold of the I value $I_{i\text{threshold}}$, and the adaptive parameters corresponding to the I value
The target threshold $I_{i\text{threshold}}$: within the $i$-th cycle period, the target threshold $I_{i\text{threshold}}$ is set to be 1/100 to 1/2 of the average value of the absolute values of the $D_{i\text{err}}$, wherein the average value of the absolute values of the $D_{i\text{err}}$

described here refers to the average value of the absolute values of the diameter differences of the *M+1* cycle periods, i.e., the average value of the absolute value of the diameter difference of the *i*-th cycle period and the absolute values of the diameter differences of the *M* cycle periods preceding the *i*-th cycle period.

The adaptive parameters corresponding to the I value include: $\alpha_{i_{a2}}$ and $\beta_{i_{a2}}$, wherein the $\alpha_{i_{a2}}$ is set to be 1/1000 to 1/10000 of the $I_{(i-1)_{corrected}}$, and the $\beta_{i_{a2}}$ is set to be 1/10000 to 1/100000 of the $I_{(i-1)_{corrected}}$.

c. setting the target threshold of the D value $D_{i_{threshold}}$, and the adaptive parameters corresponding to the D value

The target threshold $D_{i_{threshold}}$: within the *i*-th cycle period, the target threshold $D_{i_{threshold}}$ is set to be 1/100 to 1/2 of the standard deviation of the absolute values of the $D_{i_{err}}$, wherein the standard deviation of the absolute values of the $D_{i_{err}}$ described here refers to the standard deviation of the absolute values of the diameter differences of the *M+1* cycle periods, i.e., the standard deviation of the absolute value of the diameter difference of the *i*-th cycle period and the absolute values of the diameter differences of the M cycle periods preceding the *i*-th cycle period.

The adaptive parameters corresponding to the D value include: $\alpha_{i_{a3}}$ and $\beta_{i_{a3}}$, wherein the $\alpha_{i_{a3}}$ is set to be 1/1000 to 1/10000 of the $D_{(i-1)_{corrected}}$, and the $\beta_{i_{a3}}$ is set to be 1/10000 to 1/100000 of the $D_{(i-1)_{corrected}}$.

Step 3: within the *i*-th cycle period, calculating the corrected values corresponding to the initial values of the P value, the I value and the D value $P_{i_{corrected}}$, $I_{i_{corrected}}$ and $D_{i_{corrected}}$, wherein the calculating methods are respectively as follows:

a. calculating the corresponding corrected value of the initial value of the P value, by using the calculating formula (2):

$$P_{i_{corrected}} = P_{(i-1)_{corrected}} + \left( \left| D_{i_{err}} \right| - P_{i_{threshold}} \right) \times \alpha_{i_{a1}} + \int_0^t \left( \left| D_{i_{err}} \right| - P_{i_{threshold}} \right) \times \beta_{i_{a1}}$$

b. calculating the corresponding corrected value of the initial value of the I value, by using the calculating formula (3):

$$I_{i_{corrected}} = I_{(i-1)_{corrected}} + \left( \overline{\left| D_{j_{err}} \right|} - I_{i_{threshold}} \right) \times \alpha_{i_{a2}} + \int_0^t \left( \overline{\left| D_{j_{err}} \right|} - I_{i_{threshold}} \right) \times \beta_{i_{a2}}$$

c. calculating the corresponding corrected value of the initial value of the D value, by using the calculating formula (4):

$$D_{i_{corrected}} = D_{(i-1)_{corrected}} + \left( \sqrt{\frac{1}{M+1}\sum\left(\left|D_{j_{err}}\right|\right)^2} - D_{i_{threshold}} \right) \times \alpha_{i_{a3}} + \int_0^t \left( \sqrt{\frac{1}{M+1}\sum\left(\left|D_{j_{err}}\right|\right)^2} - D_{i_{threshold}} \right) \times \beta_{i_{a3}}$$

The meanings of the symbols in the formulas (2)-(4) may refer to the description on the corresponding formulas in the embodiment corresponding to Fig. 1, and is not discussed here further.

The description will be made by using *i=N,* i.e., the *N*-th cycle period, as the example.

Within the *N*-th cycle period, the absolute value of the diameter difference $D_{N_{err}}$ between the system-fed-back diameter and the target crystal diameter is 0.6, and accordingly the target threshold $P_{N_{threshold}}$ may be set to be in the range of 0.3-0.006. If the initial value of the P value $P_{(N-1)_{corrected}}$ is 3, the value range of $\alpha_{N_{a1}}$ may be 0.003-0.0003, and the value range of $\beta_{N_{a1}}$ may be 0.0003-0.00003.

Within the *N*-th cycle period, the average value of the absolute values of all of the diameter differences from the first cycle period to the *N*-th cycle period is 0.4, and accordingly the value range of the target threshold $I_{N_{threshold}}$ may be 0.2-0.004. If the initial value of the I value $I_{(N-1)_{corrected}}$ is 0.05, the value range of $\alpha_{N_{a2}}$ may be 0.00005-0.000005, and the value range of $\beta_{N_{a2}}$ may be 0.000005-0.0000005.

Within the *N*-th cycle period, the standard deviation of the absolute values of all of the diameter differences from the first cycle period to the *N*-th cycle period is 0.04, and accordingly the value range of the target threshold $D_{N_{threshold}}$ may be 0.02-0.0004. If the initial value of the D value $D_{(N-1)_{corrected}}$ is 600, the value range of $\alpha_{N_{a3}}$ may be 0.6-0.06, and the value range of $\beta_{N_{a3}}$ may be 0.06-0.006.

Particularly, within the *N*-th cycle period, it is set that the initial value of the P value $P_{(N-1)_{corrected}}$=3, $P_{N_{corrected}}$=0.1, $\alpha_{N_{a1}}$ =0.003 and $\beta_{N_{a1}}$ =0.0005, and the absolute value of the deviation of the crystal diameter within the period $D_{N_{err}}$ is

0.6mm.

According to the formula (2), it is obtained that $P_{N_{\text{corrected}}}$ =3+(0.6-0.1)*0.003+0.5*0.0005=3.00175. Therefore, within the ($N$+1)-th cycle period, the initial value of the P value is set to be $P_{N_{\text{corrected}}}$ =3.00175. Within the ($N$+1)-th cycle period, it is calculated out that the absolute value of the diameter deviation $D_{(N+1)_{err}}$ is 0.05mm, and accordingly it is set that $P_{(N+1)_{\text{threshold}}}$ =0.005, $\alpha_{(N+1)_{a1}}$ =0.003 and $\beta_{(N+1)_{a1}}$ =0.0005. According to the formula (2), it can be obtained that, within the ($N$+1)-th cycle period $P_{(N+1)_{\text{correted}}}$ =3.00175+(0.05-0.005)*0.003+0.045*0.0005=3.0019075. Accordingly, $P_{(N+2)_{\text{corrected}}}$ is calculated according to the corrected value of the ($N$+1)-th cycle period $P_{(N+1)_{\text{corrected}}}$, and then the circulated calculation is performed.

In the same manner, within the $N$-th cycle period, the initial value and the target threshold $I_{N_{\text{threshold}}}$ of the I value and the adaptive parameters corresponding to the I value $\alpha_{N_{a2}}$ and $\beta_{N_{a2}}$ are set, and the corrected value corresponding to the initial value of the I value $I_{N_{\text{corrected}}}$ is calculated out. Within the ($N$+1)-th cycle period, the initial value of the I value is set to be $I_{N_{\text{corrected}}}$, the corrected value $I_{(N+1)_{\text{corrected}}}$ is calculated, and then the circulated calculation is performed.

In the same manner, within the $N$-th cycle period, the initial value $D_{(N-1)_{\text{corrected}}}$ and the target threshold $D_{N_{\text{threshold}}}$ of the D value and the adaptive parameters corresponding to the D value $\alpha_{N_{a3}}$ and $\beta_{N_{a3}}$ are set, and the corrected value corresponding to the initial value of the D value $D_{N_{\text{corrected}}}$ is calculated out. Within the ($N$+1)-th cycle period, the initial value of the D value is set to be $D_{N_{\text{corrected}}}$, the corrected value $D_{(N+1)_{\text{corrected}}}$ is calculated, and then the circulated calculation is performed.

The third step: diameter controlling.

Within the $N$-th cycle period, according to the $P_{N_{\text{corrected}}}$, the $I_{N_{\text{corrected}}}$ and the $D_{N_{\text{corrected}}}$ calculated out in the second step, by using the PID controlling method, the crystal diameter within the $N$-th cycle period is controlled. Particularly, the PID controlling method may be used to control the crystal growth speed, and in turn control the crystal growth diameter, and certainly, the PID controlling method may also be used to control the crystal growth temperature, and in turn control the crystal growth diameter.

Taking controlling the crystal growth speed by using the PID controlling method as the example, in the actual process of crystal constant-diameter growth, by regulating the crystal growth speed, the deviation of the crystal growth diameter is controlled. Because, according to the influence on the crystal growth speed by the PID parameter values, suitable initial values are set, and in turn the initial values are corrected to control the crystal growth. The calculation principle of controlling the crystal growth speed by using the PID controlling method is as follows:

$$V = V_0 + \Delta Di * P + \int_0^{t1} \Delta Di * I + \frac{dDi}{dt} * D$$

wherein $V_0$ represents the initial speed of crystal growth, $V$ represents the crystal growth speed, $\Delta Di$ represents the deviation between the actual crystal growth diameter and the target crystal growth diameter, $Di$ represents the crystal growth diameter, and $t1$ represents the crystal growth duration.

As shown in Figs. 2 and 3, Fig. 2 is curves of the variations of the crystal-pulling-rate fluctuation amplitude and the crystal-diameter deviation with the crystal constant-diameter length during the process of the controlling of the crystal growth by using the PID controlling method, wherein the P value, the I value and the D value are not corrected. L1 represents the fluctuation amplitude of the actual crystal pulling rate, L2 represents the difference between the actual crystal diameter and the target crystal diameter, the number axis on the left of Fig. 2 represents the value of the fluctuation amplitude of the crystal pulling rate, the number axis on the right represents the diameter difference, and the horizontal coordinate represents the constant-diameter length of the crystal. It can be known from Fig. 2 that the fluctuation amplitude of the crystal pulling rate is not constant, wherein the fluctuation amplitude is from -30mm/h to +60mm/h, and the amplitude reaches 90mm/h, and the range of the fluctuation of the diameter difference is $\pm$2mm.

Fig. 3 is curves of the variations of the crystal-pulling-rate fluctuation amplitude and the crystal-diameter deviation with the crystal constant-diameter length during the process of the controlling of the crystal growth by using the PID controlling method, wherein the P value, the I value and the D value have been corrected. L3 represents the fluctuation amplitude of the actual crystal pulling rate, L4 represents the difference between the actual crystal diameter and the target crystal diameter, the number axis on the left of Fig. 3 represents the value of the fluctuation amplitude of the crystal pulling rate, the number axis on the right represents the diameter difference, and the horizontal coordinate represents the constant-diameter length of the crystal. It can be known from Fig. 3 that, after 50mm of constant-diameter growth, the fluctuation amplitude of the pulling rate is maintained at -15mm/h to +20mm/h, the amplitude is approximately 35mm/h, and the range of the fluctuation of the diameter is $\pm$1mm.

By comparing the fluctuation amplitudes of the crystal pulling rate and the diameter deviations in Fig. 2 and Fig. 3, it can be known that, by self-adaptively correcting the PID parameter values, the controlling level of the crystal diameter can be automatically adjusted, thereby controlling the crystal pulling rate and controlling the crystal diameter better.

The method for controlling constant-diameter growth of monocrystalline silicon according to the embodiments of the present disclosure acquires PID initial values of an $i$-th cycle period, wherein $i \geq 1$; corrects the PID initial values of the $i$-th cycle period, and obtains PID corrected values of the $i$-th cycle period; and according to the PID corrected values of the $i$-th cycle period, controls a crystal growth diameter of the $i$-th cycle period. The method, by correcting in real time the PID values of each of the cycle periods in the process of the crystal constant-diameter growth, automatically adjusts the controlling level of the crystal constant-diameter growth, to in turn control the crystal diameter better.

On the basis of the method for controlling constant-diameter growth of monocrystalline silicon described in the above embodiment corresponding to Fig. 1, the apparatus embodiments of the present disclosure are provided below, and may be used to implement the process embodiments of the present disclosure.

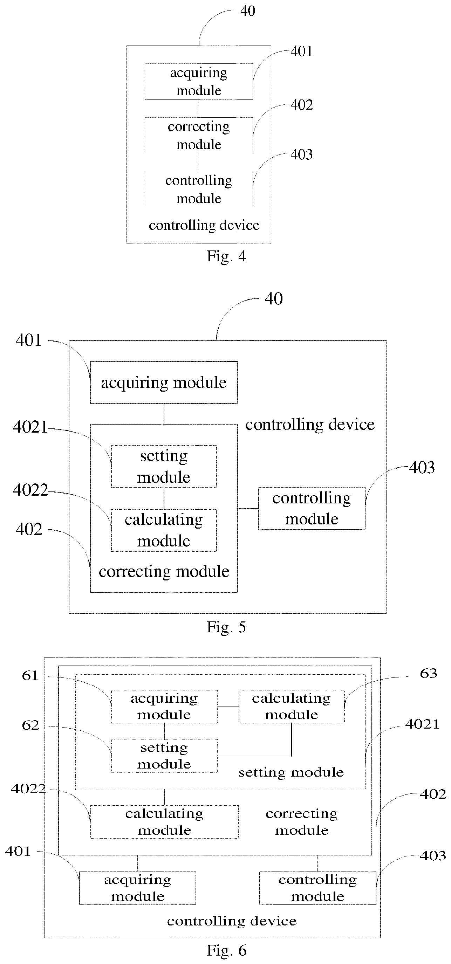

An embodiment of the present disclosure provides an apparatus for controlling constant-diameter growth of monocrystalline silicon. As shown in Fig. 4, the controlling apparatus 40 comprises: an acquiring module 401, a correcting module 402 and a controlling module 403;

the acquiring module 401 is configured for acquiring PID initial values of an $i$-th cycle period, wherein the PID initial values include an initial value of a proportion component P, an initial value of an integration component I and an initial value of a differentiation component D, and $i \geq 1$;

the correcting module 402 is configured for correcting the PID initial values of the $i$-th cycle period, and obtaining PID corrected values of the $i$-th cycle period, wherein the PID corrected values include a corrected value of the proportion component P, a corrected value of the integration component I and a corrected value of the differentiation component D; and

the controlling module 403 is configured for, according to the PID corrected values of the $i$-th cycle period, controlling a crystal growth diameter of the $i$-th cycle period.

In an embodiment, the acquiring module 401 is configured for determining PID corrected values of an $(i-1)$-th cycle period to be the PID initial values of the $i$-th cycle period.

In an embodiment, as shown in Fig. 5, the correcting module 402 comprises: a setting module 4021 and a calculating module 4022;

the setting module 4021 is configured for setting, in the $i$-th cycle period, a target threshold of the proportion component P and a corresponding adaptive parameter, a target threshold of the integration component I and a corresponding adaptive parameter and a target threshold of the differentiation component D and a corresponding adaptive parameter;

the calculating module 4022 is configured for, according to the target threshold of the proportion component P and the corresponding adaptive parameter, calculating to obtain the corrected value of the proportion component P;

the calculating module 4022 is configured for, according to the target threshold of the integration component I and the corresponding adaptive parameter, calculating to obtain the corrected value of the integration component I; and

the calculating module 4022 is configured for, according to the target threshold of the differentiation component D and the corresponding adaptive parameter, calculating to obtain the corrected value of the differentiation component D.

As shown in Fig. 6, the setting module 4021 comprises: an acquiring module 61, a setting module 62 and a calculating module 63.

In an embodiment, the acquiring module 61 is configured for acquiring a diameter difference of the $i$-th cycle period;

the setting module 62 is configured for setting 1/100-1/2 of an absolute value of the diameter difference of the $i$-th cycle period to be the target threshold of the proportion component P;

the setting module 62 is configured for setting 1/1000-1/10000 of the initial value of the proportion component P of the $i$-th cycle period to be a first adaptive parameter of the proportion component P; and

the setting module 62 is configured for setting 1/10000-1/100000 of the initial value of the proportion component P of the $i$-th cycle period to be a second adaptive parameter of the proportion component P.

In an embodiment, the acquiring module 61 is configured for acquiring diameter differences of the $i$-th cycle period and M cycle periods preceding the $i$-th cycle period, wherein $M \leq i-1$;

the calculating module 63 is configured for calculating an average value of all of the diameter differences of the $M+1$ cycle periods;

the setting module 62 is configured for setting 1/100-1/2 of the average value to be the target threshold of the integration component I;

the setting module 62 is configured for setting 1/1000-1/10000 of the initial value of the integration component I of the $i$-th cycle period to be a first adaptive parameter of the integration component I; and

the setting module 62 is configured for setting 1/10000-1/100000 of the initial value of the integration component I of the $i$-th cycle period to be a second adaptive parameter of the integration component I.

In an embodiment, the acquiring module 61 is configured for acquiring diameter differences of the $i$-th cycle period and M cycle periods preceding the $i$-th cycle period, wherein $M \leq i-1$;

the calculating module 63 is configured for calculating a standard deviation of all of the diameter differences of the $M+1$ cycle periods;

the setting module 62 is configured for setting 1/100-1/2 of the standard deviation to be the target threshold of the differentiation component D;

the setting module 62 is configured for setting 1/1000-1/10000 of the initial value of the differentiation component D of the $i$-th cycle period to be a first adaptive parameter of the differentiation component D; and

the setting module 62 is configured for setting 1/10000-1/100000 of the initial value of the differentiation component D of the $i$-th cycle period to be a second adaptive parameter of the differentiation component D.

In an embodiment, the calculating module 4022 is configured for, according to the diameter difference of the $i$-th cycle period and the target threshold of the proportion component P and the corresponding adaptive parameter, by using a first formula, calculating to obtain the corrected value of the proportion component P, wherein the first formula comprises:

$$ P_{i_{\text{corrected}}} = P_{(i-1)_{\text{corrected}}} + \left( \left| D_{i_{err}} \right| - P_{i_{\text{threshold}}} \right) \times \alpha_{i_{a1}} + \int_0^t \left( \left| D_{i_{err}} \right| - P_{i_{\text{threshold}}} \right) \times \beta_{i_{a1}} $$

wherein $P_{i_{\text{corrected}}}$ represents the corrected value of the proportion component P of the $i$-th cycle period, $P_{(i-1)_{\text{corrected}}}$ represents the initial value of the proportion component P of the $i$-th cycle period, $D_{i_{err}}$ represents the diameter difference of the $i$-th cycle period, $\alpha_{i_{a1}}$ represents the first adaptive parameter of the proportion component P, $\beta_{i_{a3}}$ represents the second adaptive parameter of the proportion component P, $P_{i_{\text{threshold}}}$ represents the target threshold of the proportion component P of the $i$-th cycle period, and t represents the duration of the cycle period.

In an embodiment, the calculating module 4022 is configured for, according to the diameter difference and the target threshold of the integration component I and the corresponding adaptive parameter, by using a second formula, calculating to obtain the corrected value of the integration component I, wherein the second formula comprises:

$$ I_{i_{\text{corrected}}} = I_{(i-1)_{\text{corrected}}} + \left( \overline{\left| D_{j_{err}} \right|} - I_{i_{\text{threshold}}} \right) \times \alpha_{i_{a2}} + \int_0^t \left( \overline{\left| D_{j_{err}} \right|} - I_{i_{\text{threshold}}} \right) \times \beta_{i_{a2}} $$

wherein $I_{i_{\text{corrected}}}$ represents the corrected value of the integration component I of the $i$-th cycle period, $I_{(i-1)_{\text{corrected}}}$ represents the initial value of the integration component I of the $i$-th cycle period, $D_{j_{err}}$ represents the diameter difference of the $i$-th cycle period in $M$+1 cycle periods, $\overline{\left| D_{j_{err}} \right|}$ represents the average value of the absolute values of all of the diameter differences in the $M$+1 cycle periods, $\alpha_{i_{a2}}$ represents the first adaptive parameter of the integration component I of the $i$-th cycle period, $\beta_{i_{a2}}$ represents the second adaptive parameter of the integration component I of the $i$-th cycle period, $I_{i_{\text{threshold}}}$ represents the target threshold of the integration component I of the $i$-th cycle period, and t represents the duration of the cycle period.

In an embodiment, the calculating module 4022 is configured for, according to the diameter difference and the target threshold of the differentiation component D and the corresponding adaptive parameter, by using a third formula, calculating to obtain the corrected value of the differentiation component D, wherein the third formula comprises:

$$ D_{i_{\text{corrected}}} = D_{(i-1)_{\text{corrected}}} + \left( \sqrt{\frac{1}{M+1} \sum \left( \left| D_{j_{err}} \right| \right)^2} - D_{i_{\text{threshold}}} \right) \times \alpha_{i_{a3}} + \int_0^t \left( \sqrt{\frac{1}{M+1} \sum \left( \left| D_{j_{err}} \right| \right)^2} - D_{i_{\text{threshold}}} \right) \times \beta_{i_{a3}} $$

wherein $D_{i_{\text{corrected}}}$ represents the corrected value of the differentiation component D of the $i$-th cycle period, $D_{(i-1)_{\text{corrected}}}$ represents the initial value of the differentiation component D of the $i$-th cycle period, $D_{j_{err}}$ represents the diameter difference of the $i$-th cycle period in $M$+1 cycle periods, $D_{i_{\text{threshold}}}$ represents the target threshold of the differentiation component D of the $i$-th cycle period, $\alpha_{i_{a3}}$ represents the first adaptive parameter of the differentiation component D of the $i$-th cycle period, $\beta_{i_{a3}}$ represents the second adaptive parameter of the differentiation component D of the $i$-th cycle period, and t represents the duration of the cycle period.

The apparatus for controlling constant-diameter growth of monocrystalline silicon according to the embodiments of the present disclosure acquires PID initial values of an $i$-th cycle period, wherein $i \geq 1$; corrects the PID initial values of the $i$-th cycle period, and obtains PID corrected values of the $i$-th cycle period; and according to the PID corrected values of the $i$-th cycle period, controls a crystal growth diameter of the $i$-th cycle period. The method, by correcting in real time the PID values of each of the cycle periods in the process of the crystal constant-diameter growth, automatically adjusts the controlling level of the crystal constant-diameter growth, to in turn control the crystal diameter better.

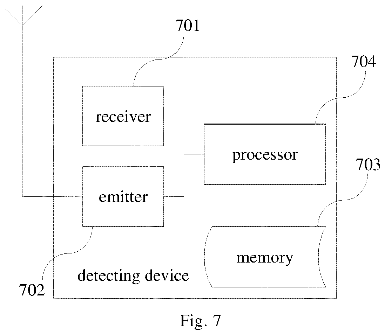

As shown in Fig. 7, an embodiment of the present disclosure further provides a device for controlling constant-diameter growth of monocrystalline silicon, wherein the device for controlling constant-diameter growth of monocrystalline silicon comprises a receiver 701, a transmitter 702, a memory 703 and a processor 704, the transmitter 702 and the memory 703 are connected to the processor 704, the memory 703 stores at least one computer instruction, and the processor 704 is configured to load and execute the at least one computer instruction, to implement the method for controlling constant-diameter growth of monocrystalline silicon described in the above embodiment corresponding to Fig. 1.

On the basis of the method for controlling constant-diameter growth of monocrystalline silicon described in the above embodiment corresponding to Fig. 1, an embodiment of the present disclosure further provides a computer-readable storage medium. For example, the non-transitory computer-readable storage medium may be a Read Only Memory (ROM), a Random Access Memory (RAM), a CD-ROM, a magnetic tape, a floppy disk, an optical data storage device and so on. The storage medium stores at least one computer instruction, to implement the method for controlling constant-diameter growth of monocrystalline silicon described in the above embodiment corresponding to Fig. 1.

A person skilled in the art can understand that all or some of the steps for implementing the above embodiments may be completed by hardware, and may also be completed by using a program to instruct relevant hardware. The program may be stored in a computer-readable storage medium. The above-mentioned storage medium may be a read only memory, a magnetic disk, an optical disk and so on.

A person skilled in the art, after considering the description and implementing the contents disclosure herein, will readily envisage other embodiments of the present disclosure. The present disclosure aims at encompassing any variations, uses or adaptative alternations of the present disclosure, wherein those variations, uses or adaptative alternations follow the general principle of the present disclosure and include common knowledge or common technical means in the art that are not disclosed by the present disclosure. The description and the embodiments are merely deemed as exemplary, and the true scope and spirit of the present disclosure are presented by the following claims.

Finally, it should be noted that the above embodiments are merely intended to explain the technical solutions of the present application, and not to limit them. Although the present application is explained in detail by referring to the above embodiments, a person skilled in the art should understand that he can still modify the technical solutions set forth by the above embodiments, or make equivalent substitutions to part of the technical features of them. However, those modifications or substitutions do not make the essence of the corresponding technical solutions depart from the spirit and scope of the technical solutions of the embodiments of the present application.

### Claims

1.    A method for controlling constant-diameter growth of monocrystalline silicon, wherein the method comprises:

   acquiring PID initial values of an $i$-th cycle period, wherein the PID initial values include an initial value of a proportion component P, an initial value of an integration component I and an initial value of a differentiation component D, and $i \geq 1$;
   correcting the PID initial values of the $i$-th cycle period, and obtaining PID corrected values of the $i$-th cycle period, wherein the PID corrected values include a corrected value of the proportion component P, a corrected value of the integration component I and a corrected value of the differentiation component D; and
   according to the PID corrected values of the $i$-th cycle period, controlling a crystal growth diameter of the $i$-th cycle period.

2.    The method according to claim 1, wherein the step of acquiring the PID initial values of the $i$-th cycle period comprises:
   determining PID corrected values of an $(i\text{-}1)$-th cycle period to be the PID initial values of the $i$-th cycle period.

3.    The method according to claim 1, wherein the step of correcting the PID initial values of the $i$-th cycle period, and obtaining the PID corrected values of the $i$-th cycle period comprises:

   setting, in the $i$-th cycle period, a target threshold of the proportion component P and a corresponding adaptive parameter, a target threshold of the integration component I and a corresponding adaptive parameter and a target threshold of the differentiation component D and a corresponding adaptive parameter;
   according to the target threshold of the proportion component P and the corresponding adaptive parameter, calculating to obtain the corrected value of the proportion component P;
   according to the target threshold of the integration component I and the corresponding adaptive parameter, calculating to obtain the corrected value of the integration component I; and
   according to the target threshold of the differentiation component D and the corresponding adaptive parameter, calculating to obtain the corrected value of the differentiation component D.

4. The method according to claim 3, wherein the step of setting the target threshold of the proportion component P of the $i$-th cycle period and the corresponding adaptive parameter comprises:

acquiring a diameter difference of the $i$-th cycle period, wherein the diameter difference is a difference between a target crystal diameter and a real-time crystal diameter;
setting 1/100-1/2 of an absolute value of the diameter difference of the $i$-th cycle period to be the target threshold of the proportion component P;
setting 1/1000-1/10000 of the initial value of the proportion component P of the $i$-th cycle period to be a first adaptive parameter of the proportion component P; and
setting 1/10000-1/100000 of the initial value of the proportion component P of the $i$-th cycle period to be a second adaptive parameter of the proportion component P.

5. The method according to claim 4, wherein the step of, according to the target threshold of the proportion component P and the corresponding adaptive parameter, calculating to obtain the corrected value of the proportion component P comprises:
according to the diameter difference of the $i$-th cycle period and the target threshold of the proportion component P and the corresponding adaptive parameter, by using a first formula, calculating to obtain the corrected value of the proportion component P, wherein the first formula comprises:

$$P_{i_{\text{corrected}}} = P_{(i-1)_{\text{corrected}}} + \left( \left| D_{i_{err}} \right| - P_{i_{\text{threshold}}} \right) \times \alpha_{i_{a1}} + \int_0^t \left( \left| D_{i_{err}} \right| - P_{i_{\text{threshold}}} \right) \times \beta_{i_{a1}}$$

wherein $P_{i_{\text{corrected}}}$ represents the corrected value of the proportion component P of the $i$-th cycle period, $P_{(i-1)_{\text{corrected}}}$ represents the initial value of the proportion component P of the $i$-th cycle period, $D_{i_{err}}$ represents the diameter difference of the $i$-th cycle period, $\alpha_{i_{a1}}$ represents the first adaptive parameter of the proportion component P, $\beta_{i_{a3}}$ represents the second adaptive parameter of the proportion component P, $P_{i_{\text{threshold}}}$ represents the target threshold of the proportion component P of the $i$-th cycle period, and $t$ represents the duration of the cycle period.

6. The method according to claim 4, wherein the step of acquiring the diameter difference of the $i$-th cycle period comprises:

collecting an initial crystal diameter of the $i$-th cycle period;
setting the target crystal diameter of the $i$-th cycle period; and
according to the crystal growth diameter of the $i$-th cycle period and the target crystal diameter of the $i$-th cycle period, calculating to obtain the diameter difference of the $i$-th cycle period.

7. The method according to claim 3, wherein the step of setting the target threshold of the integration component I of the $i$-th cycle period and the corresponding adaptive parameter comprises:

acquiring diameter differences of the $i$-th cycle period and $M$ cycle periods preceding the $i$-th cycle period, wherein $M \leq i$-1;
calculating an average value of all of the diameter differences of the $M$+1 cycle periods;
setting 1/100-1/2 of the average value to be the target threshold of the integration component I;
setting 1/1000-1/10000 of the initial value of the integration component I of the $i$-th cycle period to be a first adaptive parameter of the integration component I; and
setting 1/10000-1/100000 of the initial value of the integration component I of the $i$-th cycle period to be a second adaptive parameter of the integration component I.

8. The method according to claim 7, wherein the step of, according to the diameter difference and the target threshold of the integration component I and the corresponding adaptive parameter, calculating to obtain the corrected value of the integration component I comprises:
according to the diameter difference and the target threshold of the integration component I and the corresponding adaptive parameter, by using a second formula, calculating to obtain the corrected value of the integration component I, wherein the second formula comprises:

$$I_{i_{\text{corrected}}} = I_{(i-1)_{\text{corrected}}} + \left( \overline{\left| D_{j_{err}} \right|} - I_{i_{\text{threshold}}} \right) \times \alpha_{i_{a2}} + \int_0^t \left( \overline{\left| D_{j_{err}} \right|} - I_{i_{\text{threshold}}} \right) \times \beta_{i_{a2}}$$

wherein $I_{i_{\text{corrected}}}$ represents the corrected value of the integration component I of the $i$-th cycle period, $I_{(i-1)_{\text{corrected}}}$ represents the initial value of the integration component I of the $i$-th cycle period, $D_{j_{err}}$ represents the diameter difference of the $i$-th cycle period in $M$+1 cycle periods, $\overline{|D_{j_{err}}|}$ represents the average value of the absolute values of all of the diameter differences in the $M$+1 cycle periods, $\alpha_{i_{a2}}$ represents the first adaptive parameter of the integration component I, $\beta_{i_{a2}}$ represents the second adaptive parameter of the integration component I, $I_{i_{\text{threshold}}}$ represents the target threshold of the integration component I of the $i$-th cycle period, and t represents the duration of the cycle period.

9. The method according to claim 3, wherein the step of setting the target threshold of the differentiation component D of the $i$-th cycle period and the corresponding adaptive parameter comprises:

acquiring diameter differences of the $i$-th cycle period and $M$ cycle periods preceding the $i$-th cycle period, wherein $M \leq i-1$;
calculating a standard deviation of all of the diameter differences of the $M$+1 cycle periods;
setting 1/100-1/2 of the standard deviation to be the target threshold of the differentiation component D;
setting 1/1000-1/10000 of the initial value of the differentiation component D of the $i$-th cycle period to be a first adaptive parameter of the differentiation component D; and
setting 1/10000-1/100000 of the initial value of the differentiation component D of the $i$-th cycle period to be a second adaptive parameter of the differentiation component D.

10. The method according to claim 9, wherein the step of, according to the target threshold of the differentiation component D and the corresponding adaptive parameter, calculating to obtain the corrected value of the differentiation component D comprises:
according to the diameter difference and the target threshold of the differentiation component D and the corresponding adaptive parameter, by using a third formula, calculating to obtain the corrected value of the differentiation component D, wherein the third formula comprises:

$$D_{i_{\text{corrected}}} = D_{(i-1)_{\text{corrected}}} + \left( \sqrt{\frac{1}{M+1} \sum \left( \left| D_{j_{err}} \right| \right)^2} - D_{i_{\text{threshold}}} \right) \times \alpha_{i_{a3}} + \int_0^t \left( \sqrt{\frac{1}{M+1} \sum \left( \left| D_{j_{err}} \right| \right)^2} - D_{i_{\text{threshold}}} \right) \times \beta_{i_{a3}}$$

wherein $D_{i_{\text{corrected}}}$ represents the corrected value of the differentiation component D of the $i$-th cycle period, $D_{(i-1)_{\text{corrected}}}$ represents the initial value of the differentiation component D of the $i$-th cycle period, $D_{j_{err}}$ represents the diameter difference of the $i$-th cycle period in $M$+1 cycle periods, $D_{i_{\text{threshold}}}$ represents the target threshold of the differentiation component D of the $i$-th cycle period, $\alpha_{i_{a3}}$ represents the first adaptive parameter of the differentiation component D, $\beta_{i_{a3}}$ represents the second adaptive parameter of the differentiation component D, and t represents the duration of the cycle period.

11. A device for controlling constant-diameter growth of monocrystalline silicon, wherein the device for controlling constant-diameter growth of monocrystalline silicon comprises a processor and a memory, the memory stores at least one computer instruction, and the computer instruction is loaded and executed by the processor to implement the steps of the method for controlling constant-diameter growth of monocrystalline silicon according to any one of claims 1 to 10.

12. A computer-readable storage medium, wherein the storage medium stores at least one computer instruction, and the computer instruction is loaded and executed by a processor to implement the steps of the method for controlling constant-diameter growth of monocrystalline silicon according to any one of claims 1 to 10.

acquiring PID initial values of an *i*-th cycle period ⌐101

correcting the PID initial values of the *i*-th cycle period, and obtaining PID corrected values of the *i*-th cycle period ⌐102

according to the PID corrected values of the *i*-th cycle period, controlling a crystal growth diameter of the *i*-th cycle period ⌐103

Fig. 1

Fig. 2

Fig. 3

Fig. 4

Fig. 5

Fig. 6

701

704

receiver

processor

703

emitter

memory

702 detecting device

Fig. 7

## INTERNATIONAL SEARCH REPORT

| International application No. |
| --- |
| **PCT/CN2019/117202** |

**A.    CLASSIFICATION OF SUBJECT MATTER**

C30B 15/22(2006.01)i;  C30B 29/06(2006.01)i

According to International Patent Classification (IPC) or to both national classification and IPC

**B.    FIELDS SEARCHED**

Minimum documentation searched (classification system followed by classification symbols)

C30B

Documentation searched other than minimum documentation to the extent that such documents are included in the fields searched

Electronic data base consulted during the international search (name of data base and, where practicable, search terms used)

EPODOC, DWPI, CNKI, PATENTICS, CNABS, CNTXT, ISI web of science; 隆基绿能, 王正远, 李侨, 徐战军, 单晶, 硅, 生长, 提拉, CZ, 等径, 直径, 控制, 检测, PID, 周期, 循环, 批, 次, mono, single, crystal?, silicon, Czochralski, diameter, measur?, detect?, test?, cycle, step

**C.    DOCUMENTS CONSIDERED TO BE RELEVANT**

| Category* | Citation of document, with indication, where appropriate, of the relevant passages | Relevant to claim No. |
| --- | --- | --- |
| X | CN 101591802 A (HUISON-DUER CRYSTAL TECHNOLOGIES AND EQUIPMENT CO., LTD.) 02 December 2009 (2009-12-02) claim 1, and description, page 2, paragraphs 7 and 8, page 4, paragraph 3, and page 5, paragraph 7 | 1-4, 6, 7, 9 |
| X | CN 101748477 A (BEIJING TAIKE YIHANG SCIENTIFIC & TRADING CO., LTD.) 23 June 2010 (2010-06-23) claim 6, and description, paragraphs [0034] and [0044]-[0048] | 1-3 |
| X | CN 101392404 A (HUI, Mengjun) 25 March 2009 (2009-03-25) claims 1 and 2, and description, page 2, paragraph 3 to page 3, paragraph 13 | 1-3 |
| A | CN 101724891 A (JINGLONG INDUSTRY AND COMMERCE GROUP CO., LTD. et al.) 09 June 2010 (2010-06-09) entire document | 1-12 |
| A | US 2010024716 A1 (ORSCHEL BENNO et al.) 04 February 2010 (2010-02-04) entire document | 1-12 |

| ☐ Further documents are listed in the continuation of Box C. | ☑ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **06 February 2020** | **17 February 2020** |

| Name and mailing address of the ISA/CN | Authorized officer |
| --- | --- |
| **China National Intellectual Property Administration (ISA/ CN)** **No. 6, Xitucheng Road, Jimenqiao Haidian District, Beijing 100088 China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2019/117202**

| Patent document cited in search report | | | Publication date (day/month/year) | Patent family member(s) | | | Publication date (day/month/year) |
|---|---|---|---|---|---|---|---|
| CN | 101591802 | A | 02 December 2009 | None | | | |
| CN | 101748477 | A | 23 June 2010 | CN | 101748477 | B | 23 October 2013 |
| CN | 101392404 | A | 25 March 2009 | CN | 101392404 | B | 10 September 2014 |
| | | | | WO | 2010048790 | A1 | 06 May 2010 |
| CN | 101724891 | A | 09 June 2010 | CN | 101724891 | B | 10 October 2012 |
| US | 2010024716 | A1 | 04 February 2010 | JP | 5601801 | B2 | 08 October 2014 |
| | | | | KR | 20100014149 | A | 10 February 2010 |
| | | | | JP | 2010037190 | A | 18 February 2010 |
| | | | | US | 8012255 | B2 | 06 September 2011 |
| | | | | TW | I485293 | B | 21 May 2015 |
| | | | | DE | 102009035189 | A1 | 12 May 2010 |
| | | | | DE | 102009035189 | B4 | 22 June 2017 |
| | | | | TW | 201009133 | A | 01 March 2010 |
| | | | | KR | 101408629 | B1 | 17 June 2014 |
| | | | | US | 2010206219 | A1 | 19 August 2010 |
| | | | | US | 8641822 | B2 | 04 February 2014 |

Form PCT/ISA/210 (patent family annex) (January 2015)

**EP 3 798 337 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201811465277